# EUROPEAN PATENT APPLICATION

(11) **EP 4 528 298 A1**
(43) Date of publication of application: **26.03.2025**
(21) Application number: 23868551.5
(22) Date of filing: 19.09.2023
(51) Int. Cl.: G01R 31/396, G01R 31/392, G01R 31/367

(54) **DEVICE AND METHOD FOR ANALYZING LONG-TERM TEST OF BATTERY**

(30) Priority: 22.09.2022 KR 20220119985
(71) Applicant: LG Energy Solution, Ltd., Seoul 07335 (KR)
(72) Inventor: KIM, Eungyong, Daejeon 34122 (KR)
(74) Representative: Plasseraud IP
(86) International application number: PCT/KR2023/014135
(87) International publication number: WO 2024/063499

(57) **Abstract**

A battery long-term test analysis apparatus and method according to embodiments of the present invention may acquire test data of a single battery cell on which a long-term test inspection has been performed, segment the obtained test data, and obtain analysis data for analyzing the long-term test of the battery cell based on this, thereby analyzing anomalies in a single battery cell and applying to a previously designed conventional battery performance analysis device, and thus, highly reliable analysis results can be expected based on various data analysis for a single battery cell.

## Description

This application claims priority to and the benefit of Korean Patent Application No.10-2022-0119985 filed in the Korean Intellectual Property Office on September 22, 2022, the entire contents of which are incorporated herein by reference.

### [Technical Field]

The present invention relates to an apparatus and method for analyzing long-term test of battery, and more particularly, to an apparatus and method for analyzing long-term test of battery, which analyzes test data obtained by repeatedly performing tests under the same conditions on a single battery cell over a certain period of time to determine whether an abnormality has occurred in the battery.

### [Background Art]

As the price of energy sources rises due to depletion of fossil fuels and interest in environmental pollution increases, a demand for secondary batteries as an eco-friendly alternative energy source is rapidly increasing.

Among secondary batteries, lithium batteries are being applied to various industrial fields such as mobile applications, automobiles, robots, and energy storage systems as a response to today's environmental regulations and high oil price issues.

Generally, the capacity and performance of battery decreases and the battery deformation in shape progresses as the period of battery usage increases. Accordingly, in order to use batteries reliably in various industrial fields, it is most important to design batteries so that they can maintain certain characteristics even after long-term use. Accordingly, conventionally, long-term testing used to be essential in order to ensure battery reliability.

Long-term battery test inspection is a test that determines whether the battery deteriorates or abnormalities occur by repeatedly performing tests under the same conditions over a certain period of time. For example, long-term testing may include battery charge/discharge testing and high-temperature storage testing.

In general, most of battery performance tests are conducted on a battery module basis, and whether abnormalities occur is determined by comparing test data with adjacent battery cells tested under the same conditions.

Meanwhile, as described above, long-term test inspection of batteries is accompanied by deterioration of the battery cell to be inspected. Accordingly, in the past, long-term test inspection was conducted on a single battery cell, taking cost aspects into consideration.

However, in the conventional long-term test using a single battery cell, when analyzing test data results, there is no comparative data with the same degradation conditions by performing repeated tests under the same conditions, resulting in a disadvantage of low reliability in the analysis results.

### [Detailed Description of the Invention]

### [Technical Problem]

To obviate one or more problems of the related art, embodiments of the present disclosure provide an apparatus for analyzing long-term test of battery.

To obviate one or more problems of the related art, embodiments of the present disclosure also provide a method for analyzing long-term test of battery.

### [Technical Solution]

In order to achieve the objective of the present disclosure, an apparatus for analyzing long-term test inspection results of a battery cell may include a memory and a processor executing at least one instruction in the memory, and the at least one instruction may include an instruction to obtain test data of a battery cell on which a long-term test inspection was performed; an instruction to obtain analysis data including a plurality of group data obtained from the test data; and an instruction to determine whether an abnormality has occurred in the battery cell based on the analysis data.

Here, the long-term test inspection may include a plurality of tests repeatedly performed under the same condition on the battery cell over a certain period of time.

In addition the instruction to obtain analysis data may include an instruction to obtain a plurality of segmented data from the test data according to a first criterion; and an instruction to group the segmented data according to a second criterion to obtain the analysis data including the plurality of group data.

Here, the segmented data may be plural pieces of data segmented according to the first criterion which corresponds to a test cycle period of the long-term test inspection.

Furthermore, the segmented data may be charging data extracted for each test cycle of the long-term test inspection according to the first criterion which corresponds to a specific state of charge (SOC) section.

In addition, the second criterion includes a number of battery cells in a battery module to which the battery cell is applied.

The instruction to determine whether an abnormality has occurred in the battery cell may include an instruction to compare differences between the plurality of group data; and an instruction to determine that an abnormality has occurred in the battery cell when a data difference greater than a threshold occurs at a specific time point.

The instruction to determine whether an abnormality has occurred in the battery cell includes an instruction to compare deviations between the plurality of group data and determine that deterioration has occurred in the battery cell in the instance that a data deviation greater than a threshold occurs over a certain period of time.

The instruction to determine that an abnormality has occurred in the battery cell may further include an instruction to predict a cause of occurrence of the abnormality in the battery cell.

The instruction to predict a cause of occurrence of the abnormality in the battery cell may include an instruction to determine that an abnormality has occurred in the battery cell due to a physical change and an instruction to determine that an abnormality has occurred in the battery cell due to a chemical change.

According to another embodiment of the present disclosure, a method for analyzing long-term test inspection results of a battery cell may include obtaining test data of a battery cell on which a long-term test inspection was performed; obtaining analysis data including a plurality of group data obtained from the test data; and determining whether an abnormality has occurred in the battery cell based on the analysis data.

The long-term test inspection may include a plurality of tests repeatedly performed under the same conditions on the battery cell over a certain period of time.

The obtaining analysis data may include obtaining a plurality of segmented data from the test data according to a first criterion; and grouping the segmented data according to a second criterion to obtain the analysis data including the plurality of group data.

The segmented data may include plural pieces of data segmented according to the first criterion which corresponds to a test cycle period of the long-term test inspection.

The segmented data may include charging data extracted for each test cycle of the long-term test inspection according to the first criterion which corresponds to a specific state of charge (SOC) section.

The second criterion may include a number of battery cells in a battery module to which the battery cell is applied.

The determining whether an abnormality has occurred in the battery cell may include comparing differences between the plurality of group data; and determining that an abnormality has occurred in the battery cell when a data difference greater than a threshold occurs at a specific time point.

The determining whether an abnormality has occurred in the battery cell may include comparing deviations between the plurality of group data; and determining that deterioration has occurred in the battery cell in the instance that a data deviation greater than a threshold occurs over a certain period of time.

The determining whether an abnormality has occurred in the battery cell may further include predicting a cause of occurrence of the abnormality in the battery cell.

The predicting a cause of occurrence of the abnormality in the battery cell further determining that an abnormality has occurred in the battery cell due to a physical change; and determining that an abnormality has occurred in the battery cell due to a chemical change.

### [Advantageous Effects]

A battery long-term test analysis apparatus and method according to embodiments of the present invention may acquire test data of a single battery cell on which a long-term test inspection has been performed, segment the obtained test data, and obtain analysis data for analyzing the long-term test of the battery cell, thereby analyzing anomalies in a single battery cell using the analysis data and applying it to a conventional battery performance inspection which is previously designed on battery module basis, and thus, highly reliable analysis is possible.

### [Brief Description of the Drawings]

FIG. 1 is a block diagram illustrating a general method of analysing long-term battery test.
FIG. 2 is a conceptual diagram of a battery long-term test analysis apparatus according to embodiments of the present invention.
FIG. 3 is a block diagram of a battery long-term test analysis apparatus according to embodiments of the present invention.
FIG. 4 is a flowchart illustrating a long-term test analysis method operated by a processor in the battery long-term test analysis apparatus according to embodiments of the present invention.
FIG. 5 is a flowchart illustrating a method of obtaiing analysis data of the battery long-term test analysis methods according to embodiments of the present invention.
FIG. 6 is a graph illustrating a method of analyzing whether an abnormality occurs in a single battery cell of the battery long-term test analysis method according to embodiments of the present invention.
FIG. 7 is a graph for explaining occurrence of abnormalities in a single battery cell due to physical changes according to experimental examples of the present invention.
FIG. 8 is a graph for explaining the occurrence of abnormalities in a single battery cell due to chemical changes according to an experimental examples of the present invention.

1000: battery long-term test analysis apparatus
100: memory
200: processor
300: transceiver
400: input interface
500: output interface
600: storage device
700: bus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

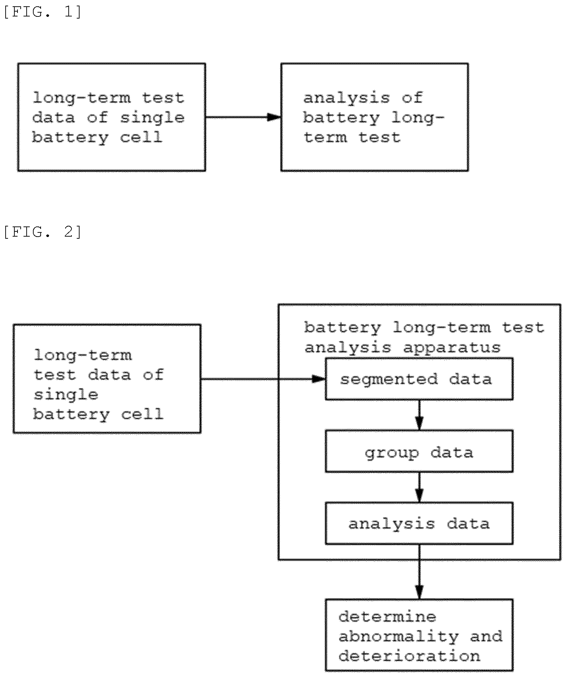

FIG. 1 is a block diagram illustrating a general method of analysing long-term battery test.

Referring to FIG. 1, a long-term battery test is a test that determines whether or not an abnormality has occurred in a battery by repeatedly performing tests under the same conditions over a certain period of time. For example, a long-term test may include charge/discharge tests and high-temperature storage tests to check a degree of battery deterioration (state of health).

In general, performance tests to improve battery reliability are conducted on a battery module basis. More specifically, the battery performance test involves testing a battery module under the same conditions and determining whether an abnormality has occurred by comparing and analyzing test data between adjacent battery cells.

Here, in the long-term test inspection of the battery, tests under the same conditions are repeatedly performed, which may lead to deterioration of at least one battery cell that is inspection target. Accordingly, in general, a specific single battery cell is selected and a long-term test inspection is performed on the selected battery cell, in consideration of cost aspects.

However, the long-term test inspection using a single battery cell has the disadvantage of lowering reliability of the inspection results because it is difficult to compare with other battery cells with similar state of health when conducting a long-term test over a certain period of time.

Accordingly, the present invention presents an long-term test inspection analysis apparatus and method in which test data is collected from a single battery cell on which a long-term test inspection was performed under certain conditions, the test data is classified and grouped according to predetermined criteria, and the grouped data is used as comparision data for analysis of long-term test results, thereby analyzing battery abnormalities with high reliability.

Hereinafter, preferred embodiments according to the present invention will be described in detail with reference to the attached drawings.

FIG. 2 is a conceptual diagram of a battery long-term test analysis apparatus according to embodiments of the present invention.

Referring to FIG. 2, the battery long-term test analysis apparatus according to embodiments of the present invention may obtain test data for a single battery cell by repeatedly performing tests under the same conditions for a certain period of time. Thereafter, the battery long-term test analysis apparatus may analyze the obtained test data to determine whether a battery cell deterioration condition or an abnormality has occurred in the battery cell.

In the following, the battery long-term test and analysis apparatus according to embodiments of the present invention will be described in more detail by hardware configuration.

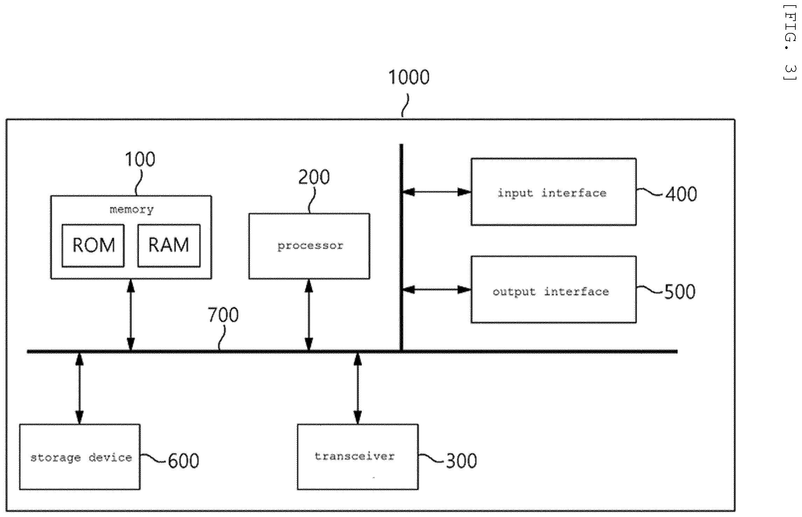

FIG. 3 is a block diagram of a battery long-term test analysis apparatus according to embodiments of the present invention.

In more detail as to each component of the battery long-term test analysis apparatus according to embodiments of the present invention referring to FIG. 3, the battery long-term test analysis apparatus may include a memory 100, a processor 200, a transceiver 300, an input interface 400, an output interface 500, and a storage device 600.

According to embodiments, respective components 100, 200, 300, 400, 500, 600 included in the battery long-term test analysis apparatus 1000 may be connected by a bus 700 to communicate with each other.

The memory 100 and the storage device 600 among the components 100, 200, 300, 400, 500, 600 may include at least one of a volatile storage medium and a non-volatile storage medium. For example, the memory 100 and the storage device 600 may include at least one of read only memory (ROM) and random access memory (RAM).

Among them, the memory 100 may include at least one instruction executed by the processor 200.

According to embodiments, the at least one instruction may include an instruction to obtain test data of a battery cell on which a long-term test inspection was performed; an instruction to obtain analysis data including a plurality of group data obtained from the test data; and an instruction to determine whether an abnormality has occurred in the battery cell based on the analysis data.

Here, the long-term test inspection may include a plurality of tests repeatedly performed under the same condition on the battery cell over a certain period of time.

In addition, the instruction to obtain analysis data may include an instruction to obtain a plurality of segmented data from the test data according to a first criterion; and an instruction to group the segmented data according to a second criterion to obtain the analysis data including the plurality of group data.

Here, the segmented data may be plural pieces of data segmented according to the first criterion which corresponds to a test cycle period of the long-term test inspection.

Furthermore, the segmented data may be charging data extracted for each test cycle of the long-term test inspection according to the first criterion which corresponds to a specific state of charge (SOC) section.

In addition, the second criterion includes a number of battery cells in a battery module to which the battery cell is applied.

The instruction to determine whether an abnormality has occurred in the battery cell may include an instruction to compare differences between the plurality of group data; and an instruction to determine that an abnormality has occurred in the battery cell when a data difference greater than a threshold occurs at a specific time point.

The instruction to determine whether an abnormality has occurred in the battery cell includes an instruction to compare deviations between the plurality of group data and determine that deterioration has occurred in the battery cell in the instance that a data deviation greater than a threshold occurs over a certain period of time.

The instruction to determine that an abnormality has occurred in the battery cell may further include an instruction to predict a cause of occurrence of the abnormality in the battery cell.

The instruction to predict a cause of occurrence of the abnormality in the battery cell may include an instruction to determine that an abnormality has occurred in the battery cell due to a physical change and an instruction to determine that an abnormality has occurred in the battery cell due to a chemical change.

Meanwhile, the processor 200 may mean a central processing unit (CPU), a graphics processing unit (GPU), or a dedicated processor on which methods according to embodiments of the present invention are performed.

The processor 200 may execute at least one program command stored in the memory 100 as described above.

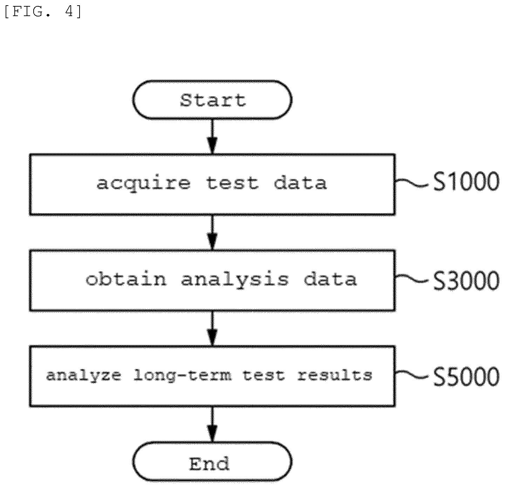

FIG. 4 is a flowchart illustrating a long-term test analysis method operated by a processor in the battery long-term test analysis apparatus according to embodiments of the present invention.

Referring to FIG. **4****,** the battery long-term test analysis apparatus according to embodiments of the present invention may acquire test data from a single battery cell according to operation of the processor 200 (S1000).

In more detail, the test data may be data obtained by performing a long-term test inspection on the single battery cell.

Here, as described above, the long-term test inspection may be an inspection in which tests under the same conditions are repeatedly performed on a single battery cell over a certain period of time in order to analyze whether the battery deteriorates or abnormalities occur.

According to an embodiment, the test data may be charge/discharge result data of a single battery cell obtained by repeatedly performing charge/discharge operations under certain conditions in order to measure a state of health of battery.

According to another embodiment, the test data may be state of charge (SoC) data of a single battery cell measured while stored for a certain period of time at a high temperature above a preset threshold to measure a state of health of battery.

Thereafter, the battery long-term test analysis apparatus may obtain analysis data by preprocessing test data obtained from the single battery cell (S3000).

Thereafter, the battery long-term test analysis apparatus may analyze the long-term test results of a specific battery cell using the analysis data (S5000). In other words, the battery long-term test analysis apparatus may determine whether an abnormality has occurred in a single battery cell based on the analysis data.

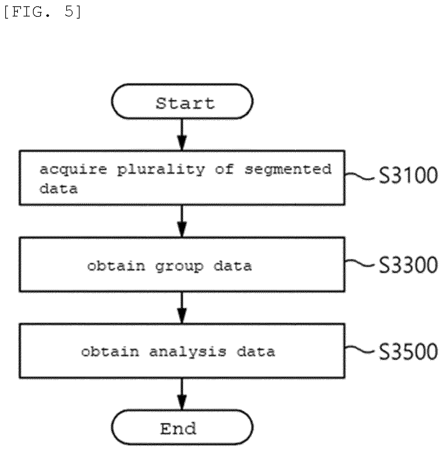

FIG. 5 is a flowchart illustrating a method of obtaiing analysis data of the battery long-term test analysis methods according to embodiments of the present invention.

Referring to FIG. 5, the battery long-term test analysis apparatus may acquire a plurality of segmented data that satisfies the first criterion among test data obtained from a single battery cell (S3100).

According to an embodiment, the battery long-term test analysis apparatus may segment test data based on a repeated test cycle period to obtain a plurality of segmented data that satisfies the first criterion. For example, the plurality of segmented data that satisfies the first criterion may be charging data measured in a specific SOC section for each cycle.

Thereafter, the battery long-term test analysis apparatus may acquire analysis data (S3500) including a plurality of group data (S3300) in which a plurality of segmented data are grouped based on a second criterion. For example, the second criterion may include a number of battery cells in the battery module to which the battery cells are applied.

To be described in more detail according to an embodiment, the battery long-term test analysis apparatus may classify a plurality of segmented data into a preset number to generate a plurality of group data. Here, the plurality of segmented data may be classified by the number of battery cells included in the battery module.

The battery long-term test analysis apparatus according to embodiments of the present invention may obtain a plurality of group data obtained by segmenting the test data obtained from a single battery cell according to a second condition and utilize the group data as comparative data for performing long-term test analysis of the single battery cell. Accordingly, the battery long-term test and analysis apparatus may provide highly reliable analysis results with improved precision by enabling data comparison even during long-term test analysis of a single battery cell.

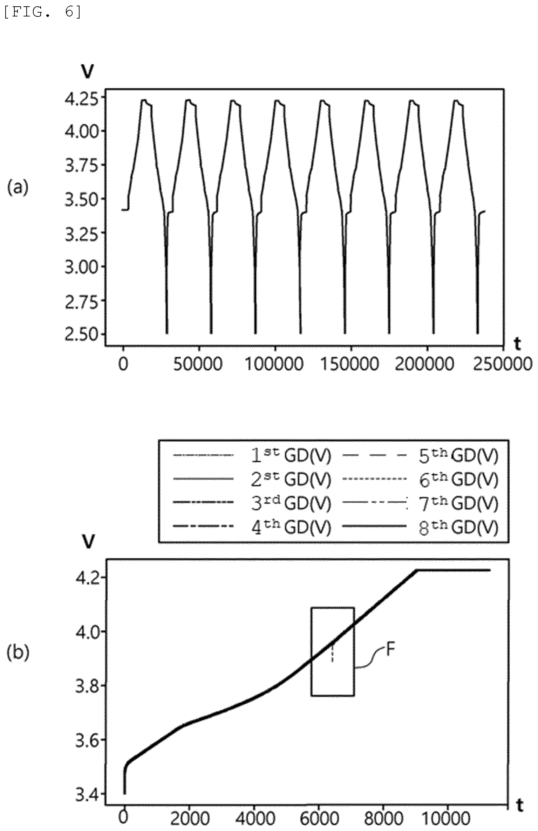

FIG. 6 is a graph illustrating a method of analyzing whether an abnormality occurs in a single battery cell of the battery long-term test analysis method according to embodiments of the present invention. In more detail, (a) of FIG. 6 is a graph of test data of a single battery cell and (b) of FIG. 6 shows an enlarged view of the area where an abnormality occurred among a plurality of segmented data of a single battery cell.

Referring to FIG. 6, the battery long-term test analysis apparatus can determine whether an abnormality or deterioration of a single battery cell has occurred based on the analysis data, as described above.

To be more specific, the battery long-term test analysis apparatus may extract a plurality of segmented data that satisfies the first criterion from continuous test data obtained from a single battery cell, as shown in(a) of FIG. 6.

Thereafter, the battery long-term test analysis apparatus may obtain group data by grouping the plurality of segmented data into a predefined number.

Thereafter, the battery long-term test analysis apparatus may display a plurality of group data on one graph plane, as shown in (b) of FIG. 6.

For example, the battery long-term test analysis apparatus may extract a plurality of segmented data that are charging data for a specific state of charge (SOC) section from the test data, divide them into 8 pieces of preset group data, and display the 8 pieces of group data on one graph plane, as shown in (b) of FIG. 6.

Thereafter, the battery long-term test analysis apparatus may compare data values of the plurality of the group data at the same time point to determine whether an abnormality or deterioration of a single battery cell has occurred.

According to an embodiment, the battery long-term test analysis apparatus may determine that defect data F is generated based on the group data when the difference in data values between the plurality of group data is greater than or equal to a threshold value. In other words, the battery long-term test analysis apparatus may determine that an abnormality has occurred in a single battery cell.

In addition, according to another embodiment, the battery long-term test analysis apparatus determine that the tested single battery cell has deteriorated in the instance that a difference of more than a certain reference occurs in continuous data values of at least one group data for a certain period compared to the data values of at least one other groups for the certain period.

Meanwhile, when defect data (F) occurs, the battery long-term test analysis apparatus may obtain at least one parameter value using the analysis data. For example, at least one parameter value may be data including group data for a certain period of time. Accordingly, the battery long-term test analysis apparatus can predict a cause of an abnormality in a single battery cell by analyzing flow of the defect data according to the at least one parameter value.

For example, the battery long-term test analysis apparatus may analyze flow of defect data (F) based on at least one parameter value based on the analysis data.

Here, the at least one parameter value may be analyzed by the battery long-term test analysis apparatus or may be obtained by inputting the analysis data into at least one previously designed battery analysis device performing a conventional module basis battery test. In other words, the battery long-term test analysis apparatus according to embodiments of the present invention may acquire analysis data including a plurality of diverse group data and apply it to an existing battery performance test device that performs inspection on a battery module basis, enabling various data analysis for a single battery cell.

According to an embodiment, the battery long-term test analysis apparatus may analyze flows of voltage, current, and temperature data for a certain period of time regarding defect data (F), and may determine whether an abnormality has occurred in a single battery cell due to physical changes due to external force.

In addition, according to another embodiment, the battery long-term test analysis apparatus may analyze flows of voltage, current, and temperature data for a certain period of time regarding defect data (F), and may determine whether an abnormality has occurred in a single battery cell due to chemical changes such as resistance or deterioration.

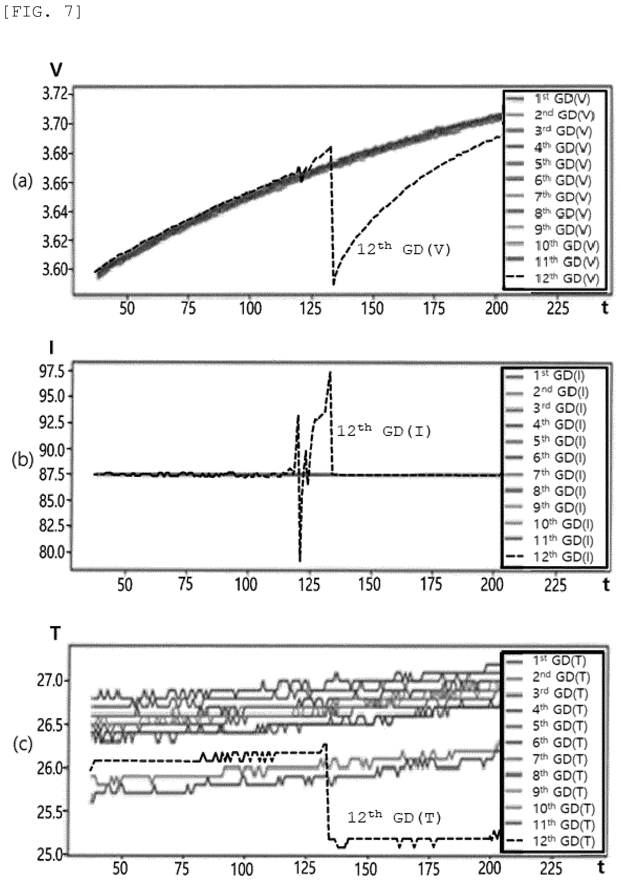

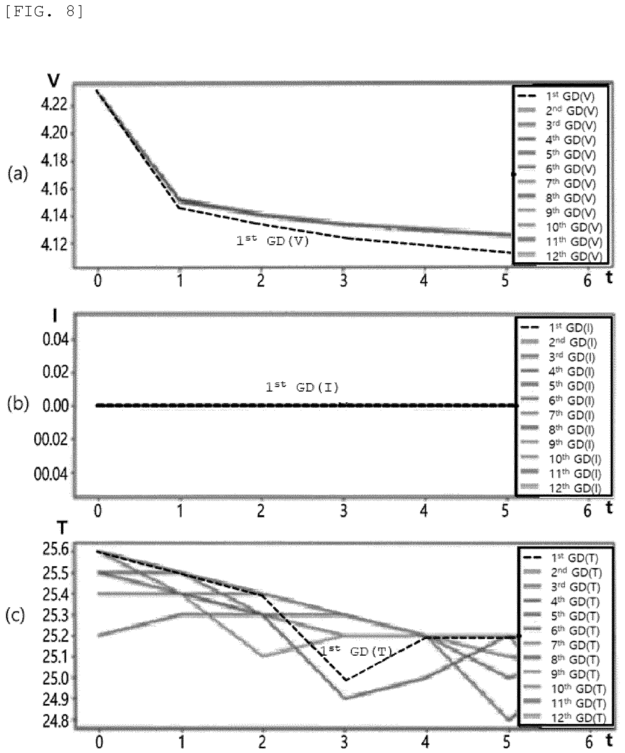

Hereinafter, a battery long-term test analysis method for predicting cause of abnormalities in a single battery cell will be described in detail, according to experimental examples of the present invention in FIGS. 7 and 8.

### Performing long-term test analysis using the battery long-term test analysis apparatus of the present invention

Using the battery long-term test analysis apparatus of the present invention, charge and discharge data of a single battery cell that underwent 1000 cycles of charge and discharge were collected.

Afterwards, the battery long-term test analysis apparatus segmented the collected charge and discharge data into 12 groups and performed long-term test analysis of a single battery cell using the group data.

FIG. 7 is a graph for explaining occurrence of abnormalities in a single battery cell due to physical changes according to experimental examples of the present invention. More specifically, (a) of FIG. 7 shows voltage graphs over time of group data of a single battery cell, (b) of FIG. 7 shows current graphs over time of group data of a single battery cell, and (c) of FIG. 7 shows temperature graphs over time of group data of a single battery cell.

Referring to FIG. 7, as a result of analysis of group data using a long-term test analysis apparatus according to embodiments of the present invention, the flows of voltage, current, and temperature data for the 12th group data within a certain period of time show difference from the flows of other group data except for the 12th group data. In other words, among group data of the single battery cells with the same state of health under the same conditions, only the 12th group data shows a different data flow pattern for a certain period of time. Accordingly, the long-term test analysis apparatus according to embodiments of the present invention may determine that a temporary abnormality in the data flow has occurred in a single battery cell due to a physical change due to an external force.

FIG. 8 is a graph for explaining the occurrence of abnormalities in a single battery cell due to chemical changes according to an experimental examples of the present invention. More specifically, (a) of FIG. 8 shows voltage graphs over time of group data of a single battery cell, (b) of FIG. 8 shows current graphs over time of group data of a single battery cell, and (c) of FIG. 8 shows temperature graphs over time of group data of a single battery cell.

Referring to FIG. 8, as a result of analysis of group data using a long-term test analysis apparatus according to embodiments of the present invention, it can be noted that the voltage flows overall decrease while the current of the group data remains the same and the temperature change for each group data is irregular. Accordingly, the long-term test analysis apparatus according to embodiments of the present invention may determine that an abnormality has occurred in a single battery cell according to a change in resistance due to deterioration, etc. In other words, the long-term test analysis apparatus according to embodiments of the present invention may determine that a problem has occurred in a single battery cell due to a chemical change.

The battery long-term test analysis apparatus and method according to embodiments of the present invention have been described above.

The battery long-term test analysis apparatus and method according to embodiments of the present invention may acquire test data of a single battery cell on which a long-term test inspection has been performed, segment the obtained test data, and obtain analysis data for analyzing the long-term test of the battery cell based on this, thereby analyzing anomalies in a single battery cell and applying to a previously designed conventional battery performance analysis device, and thus, highly reliable analysis results can be expected based on various data analysis for a single battery cell.

The operations of the method according to the embodiments and experimental examples of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, etc. The program instructions may include not only machine language code created by a compiler, but also high-level language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. An apparatus for analyzing long-term test inspection results of a battery cell, the apparatus comprising:
a memory; and
a processor executing at least one instruction in the memory,
wherein the at least one instruction includes:
an instruction to obtain test data of a battery cell on which a long-term test inspection was performed;
an instruction to obtain analysis data including a plurality of group data obtained from the test data; and
an instruction to determine whether an abnormality has occurred in the battery cell based on the analysis data.

2. The apparatus of claim 1, wherein the long-term test inspection includes a plurality of tests repeatedly performed under the same conditions on the battery cell for a certain period of time.

3. The apparatus of claim 1, wherein the instruction to obtain analysis data includes:
an instruction to obtain a plurality of segmented data from the test data according to a first criterion; and
an instruction to group the segmented data according to a second criterion to obtain the analysis data including the plurality of group data.

4. The apparatus of claim 3, wherein the segmented data includes plural pieces of data segmented according to the first criterion which corresponds to a test cycle period of the long-term test inspection.

5. The apparatus of claim 3, wherein the segmented data includes charging data extracted for each test cycle of the long-term test inspection according to the first criterion which corresponds to a specific state of charge (SOC) section.

6. The apparatus of claim 3, wherein the second criterion includes a number of battery cells in a battery module to which the battery cell is applied.

7. The apparatus of claim 1, wherein the instruction to determine whether an abnormality has occurred in the battery cell includes:
an instruction to compare differences between the plurality of group data; and
an instruction to determine that an abnormality has occurred in the battery cell when a data difference greater than a threshold occurs at a specific time point.

8. The apparatus of claim 7, wherein the instruction to determine whether an abnormality has occurred in the battery cell includes an instruction to compare deviations between the plurality of group data and determine that deterioration has occurred in the battery cell in the instance that a data deviation greater than a threshold occurs over a certain period of time.

9. The apparatus of claim 7, wherein the instruction to determine that an abnormality has occurred in the battery cell further includes an instruction to predict a cause of occurrence of the abnormality in the battery cell.

10. The apparatus of claim 9, wherein the instruction to predict a cause of occurrence of the abnormality in the battery cell includes:
an instruction to determine that an abnormality has occurred in the battery cell due to a physical change; and
an instruction to determine that an abnormality has occurred in the battery cell due to a chemical change.

11. A method for analyzing long-term test inspection results of a battery cell, the method comprising:
obtaining test data of a battery cell on which a long-term test inspection was performed;
obtaining analysis data including a plurality of group data obtained from the test data; and
determining whether an abnormality has occurred in the battery cell based on the analysis data.

12. The method of claim 11, wherein the long-term test inspection includes a plurality of tests repeatedly performed under the same conditions on the battery cell over a certain period of time.

13. The method of claim 11, wherein the obtaining analysis data includes:
obtaining a plurality of segmented data from the test data according to a first criterion; and
grouping the segmented data according to a second criterion to obtain the analysis data including the plurality of group data.

14. The method of claim 13, wherein the segmented data includes plural pieces of data segmented according to the first criterion which corresponds to a test cycle period of the long-term test inspection.

15. The method of claim 13, wherein the segmented data includes charging data extracted for each test cycle of the long-term test inspection according to the first criterion which corresponds to a specific state of charge (SOC) section.

16. The method of claim 13, wherein the second criterion includes a number of battery cells in a battery module to which the battery cell is applied.

17. The method of claim 11, wherein the determining whether an abnormality has occurred in the battery cell includes:
comparing differences between the plurality of group data; and
determining that an abnormality has occurred in the battery cell when a data difference greater than a threshold occurs at a specific time point.

18. The method of claim 17, wherein the determining whether an abnormality has occurred in the battery cell includes:
comparing deviations between the plurality of group data; and
determining that deterioration has occurred in the battery cell in the instance that a data deviation greater than a threshold occurs over a certain period of time.

19. The method of claim 17, wherein the determining whether an abnormality has occurred in the battery cell further includes:
predicting a cause of occurrence of the abnormality in the battery cell.

20. The method of claim 19, wherein the predicting a cause of occurrence of the abnormality in the battery cell includes:
determining that an abnormality has occurred in the battery cell due to a physical change; and
determining that an abnormality has occurred in the battery cell due to a chemical change.
